**Europäisches Patentamt**

(19) **European Patent Office**

**Office européen des brevets**

(11) Publication number: **0 019 150**
**B1**

(12) **EUROPEAN PATENT SPECIFICATION**

(45) Date of publication of patent specification: **18.07.84**

(21) Application number: **80102360.7**

(22) Date of filing: **30.04.80**

(51) Int. Cl.³: **G 11 C 29/00,**
**G 06 F 11/26, G 11 C 11/24**

(54) Method of testing the operation of an internal refresh counter in a random access memory and circuit for the testing thereof.

(30) Priority: **15.05.79 US 39248**

(43) Date of publication of application:
**26.11.80 Bulletin 80/24**

(45) Publication of the grant of the patent:
**18.07.84 Bulletin 84/29**

(84) Designated Contracting States:
**AT BE CH DE FR GB IT LI NL SE**

(56) References cited:
**GB - A - 2 021 826**
**US - A - 3 944 800**
**US - A - 3 961 252**
**US - A - 4 055 754**

**IEEE SPRING COMPCON, 1977, 28th February –**
**3rd March 1977, pages 183-185 San Francisco,**
**U.S.A. OWEN: "Optimized Testing of 16k**
**RAM's"**
**COMPUTER DESIGN, vol. 14, no. 5, May 1975,**
**pages 117-125, New York, U.S.A. E.R. HNATEK:**
**"4-Kilobit Memories Present a Challenge to**
**Testing"**

(73) Proprietor: **MOSTEK CORPORATION**
**1215 West Crosby Road**
**Carrollton Dallas, Texas 75006 (US)**

(72) Inventor: **Proebsting, Robert James**
**1237 Seminole**
**Richardson Texas (US)**

(74) Representative: **Patentanwälte Dipl.-Ing. A.**
**Grünecker, Dr.-Ing. H. Kinkeldey, Dr.-Ing. W.**
**Stockmair,**
**Dr. rer. nat. K. Schumann, Dipl.-Ing. P.H. Jakob,**
**Dr. rer. nat. G. Bezold Maximilianstrasse 58**
**D-8000 München 22 (DE)**

(58) References cited:
**ELECTRONICS, vol. 52, no. 4, 15th February**
**1979, pages 141-147 New York, U.S.A. FORD et**
**al.: "64-k Dynamic RAM has pin that refreshes"**
**Patent Abstracts of Japan", Vol 1, No 88, 11.**
**AUG. 1977, Page 1935E77**
**ELECTRONIC DESIGN, vol. 27, no. 13 21st June**
**1979, pages 58-64 New York, U.S.A. S. YOUNG:**
**"64-k RAM with single supply could be the**
**standard for future design"**

Courier Press, Leamington Spa, England.

IEEE SEMICONDUCTOR TEST SYMPOSIUM, 5th-7th November 1974, pages 53-71 Long Beach, U.S.A. FISCHER: "Test Problems & Solutions for 4K RAM's"

THE SEMICONDUCTOR MEMORY BOOK, Intel, Wiley editor 1978, pages 139-181 New York, U.S.A. G. FIELLAND: "Dynamic rams used with microprocessors"

## Description

This invention relates to a method of testing the operation of an internal refresh counter in a random access memory and a circuit for testing the operation of an internal refresh counter in a random access memory.

Basically the refresh function is required in dynamic memories to keep data from being lost as a result of charge leaking off memory cells over a period of time. The charge will leak off over a period of time and it is periodically restored back to its initial value by a function called "refresh". This refresh function operates on one row of memory at a time or with certain groupings of maybe two or four rows, but normally a very small fraction of the total number of rows. It is necessary to have some means, either internal within the chip or external within the system, of cycling through all the rows to refresh all of the rows within some period of time, typically in the industry about 2 milliseconds, before any given row must be refreshed again.

In the case of many random access memories (RAMs) to date, the refresh counter has been external; that is, there is a counter off the chip which cycles through and keeps track of which row was most recently refreshed and increments and refreshes the next row during the next refresh cycle. Thus, the refresh counter is required to cycle through all the rows, one row at a time, or possibly two or four rows at a time. The counter keeps track of which row has been refreshed, and cycles through until all of the rows have been refreshed within some period of time, say 2 milliseconds. The cycle then continues, so a cycle of row n followed by row n+1 followed by row n+2, etc. to row n again is performed within 2 milliseconds, repeatedly.

To test the proper function of a random access memory without an internal refresh counter is fairly straightforward. A variety of input data patterns are written into the memory and then read out to see that they exist in their entirety exactly as written. With the proper choice of patterns, this test confirms that all circuitry performs properly including the row selection and column selection circuitry. In addition, in most memory designs, such a test also confirms that a refresh function occurs on the selected row since in this case selection of a given row automatically refreshes that row. However, other RAMs have a refresh counter on the chip, and there is a very real problem in testing the refresh function on this part. The output of the refresh counter cannot be read directly. A definitive test requires the write-in data followed by a waiting period of at least long enough that the very best bit, that is a bit that has the very longest charge retention time, will guarantee to fail. When an industry specification is 2 milliseconds, meaning that all of the bits will hold data for at least 2 milliseconds, many of the bits will hold data for 200 milliseconds, or even longer. Thus a refresh cycle at 100 millisecond intervals may show that no bits have failed. Yet, that does not mean that there is not a row that was skipped by the counter as all of the bits in that row may have happened to have a refresh time that exceeded 100 milliseconds.

If there is a potential failure at 200 milliseconds, or maybe 500 milliseconds, a situation is reached where there must be a compromise between a very long test time and not absolutely guaranteeing that the part will work. To absolutely guarantee that the refresh function of the part works would require a wait long enough to be absolutely certain that a good bit would have failed without refresh. Therefore, refreshing a long enough time to guarantee that the refresh function works means taking a very long time in a test that is using some very expensive equipment. Further, less time is desirable to have a greater manufacturing throughput.

In the publication Electronics, Volume 52, No. 4, February 15, 1979, at pages 141—147, New York, USA, an article by David C. Ford et al under the title "64-K dynamic RAM has pin that refreshes" is published in which a random access memory circuit is described which has an internal refresh counter. However the article does not discuss a method or a circuit for testing the operation of the internal refresh counter.

US—A—39 94 800 and JP—A—22 441 teach a random access memory circuit having two refresh counters which are matched to ensure a proper refresh operation. Such a duplication of refresh counter, however, leads to increased manufacturing costs and consumes additional space on the chip.

It is, therefore, an object of the present invention to provide a method and a circuit by which the proper function of the operation of an internal refresh counter in a random access memory may be tested within a short time. The invention as claimed in claims 1 & 5 solves that object. The remaining claims 2—4 and 6—8 include preferred embodiments of the invention.

In operation of the invention a uniform background is written into the memory.

During a normal refresh operation, it is desirable to lock out other circuitry on the random access memory chip including the read and write circuitry. So normally, then, a refresh command activates the refresh circuitry, and a row addressed by the refresh counter rather than by an external address is cycled. If a column address strobe and a write command are given, the chip will normally ignore the signals and the write will not occur.

However, the row address strobe (RAS) is not ignored during refresh, although it normally selects an external address rather than an internal address. Also, a refresh command selects a row whose address is determined by the refresh counter. By means of the present invention therefore, during a test mode the refresh command is followed by a $\overline{RAS}$ command. If a column address strobe ($\overline{CAS}$) and a write command are then given, a bit is addressed and written by the combination. Thus, the selected row for this test is addressed by the refresh counter. The selected column may either be addressed by the refresh counter or externally addressed.

Now the above sequence is repeated until each row should have been selected and therefore written exactly once. If the refresh counter is working, it has gone to each row and if it is not working, it will have skipped one or more rows. A normal read of the memory, not using the refresh counter, is performed to see that the correct pattern was written over the background. If in each row the appropriate column is in fact written into, the refresh counter had to enable that row. If a circuit passes this test, the refresh counter is guaranteed to have addressed each row.

Further, if according to a preferred feature, the column information is written into a different location in each column, such as column 1 when refreshing the first row, column 2 on the next row, etc., it guarantees that each column is written only once. If, for example, the refresh counter somehow activated more rows than intended, the read-out would indicate this, Thus this invention provides means whereby the $\overline{CAS}$ and write circuitry are disabled when in a refresh function, yet may be enabled when in a refresh counter test mode.

Basically, $\overline{RAS}$ would normally strobe in a given row, $\overline{CAS}$ would strobe in a given column, and write would write the data of the data input into that addressed row and column. By means of this invention however a new sequence can be provided in which the refresh command strobes in a row address internally generated by the refresh counter, followed by $\overline{RAS}$ enabling the $\overline{CAS}$ and write functions, and then followed by $\overline{CAS}$ strobing in either the column whose address is dictated by the refresh counter or an address externally generated. The write command then writes the selected bit, which may be read in a normal fashion to verify refresh counter operation.

One way of carrying out the invention is described in detail below with reference to drawings which illustrate only specific embodiment, in which:

Figure 1 is a block diagram of one embodiment of the invention; and

Figure 2 is a timing diagram cooperating with the embodiment shown in Figure 1.

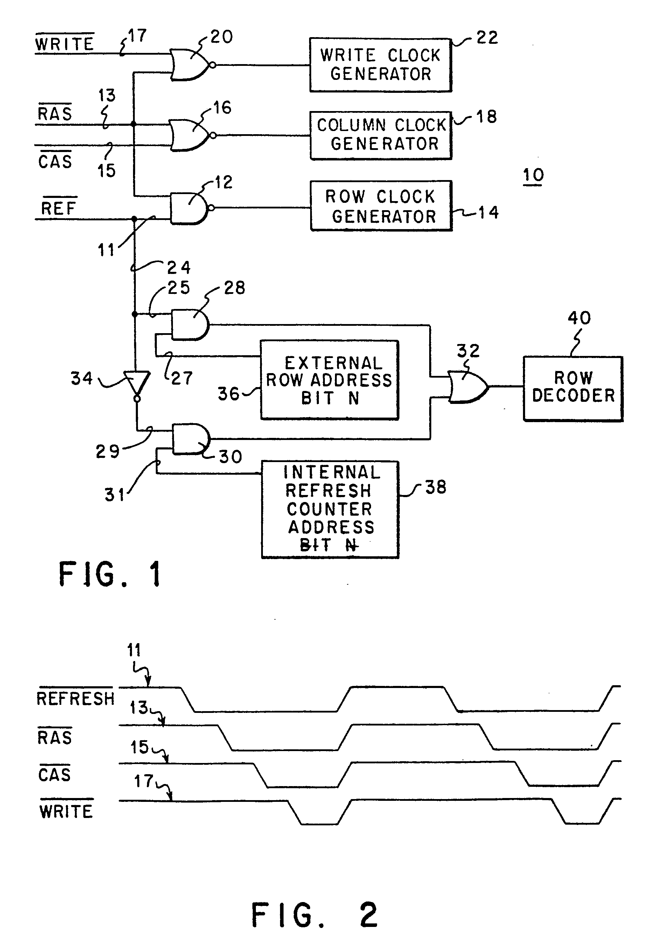

Referring now to Figure 1, the invention is shown generally at 10. A NAND-gate 12 receives inputs refresh 11 and row address strobe ($\overline{RAS}$) 13. A row clock generator 14, as in an ordinary memory, is driven by the output of NAND-gate 12, NOR-gate 16 is shown receiving the $\overline{RAS}$ input 13 and the column

address strobe ($\overline{CAS}$) 15. The output of the NOR-gate 16 drives the column clock generator 18. Also shown is a NOR-gate 20 receiving the $\overline{RAS}$ command 13 and a write signal 17. The output of the NOR-gate 20 drives the write clock generator 22. Therefore, when the $\overline{RAS}$ and refresh inputs are not both high, the row clock generator 14 will be operative. A normal state for the refresh and $\overline{RAS}$ signals 11 and 13 as high is shown in the timing diagram in Figure 2. NOR-gate 16 will drive the column clock generator 18 when $\overline{RAS}$ 13 and $\overline{CAS}$ 15 inputs are both low.

Referring now to Figure 2 under the operation of this invention, when the refresh input $\overline{REF}$ 11 and the row address-$\overline{RAS}$ input 13 both go low, the row clock generator 14 is enabled and the internal refresh counter address is selected. $\overline{CAS}$ complement 15 follows, thereby enabling the column clock generator 18. Briefly after this point, the write complement signal 17 goes low enabling the NOR-gate 20 and driving the write clock generator 22.

Signal line 24 can be seen leading from the refresh complement 11 to an input 25 to an AND-gate 28. Signal line 24 also leads to the input of an inverter 34 whose output 29 is an input to AND-gate 30. AND-gate 28 also has its other input 27 from an external row address 36. AND-gate 30 has its second input 31 from the internal refresh counter 38. The output of the AND-gate 28 and that of AND-gate 30 are inputs to an OR-gate 32 which provides one address bit to row decoder 40. Thus it can be seen when the refresh signal 11 goes low as a normal part of the refresh counter test sequence, the AND-gate 28 will be disabled and the AND-gate 30 will be enabled. In this way the external row address 36 has no effect. The internal refresh counter address 38 will propagate through the AND-gate 30. This will be passed through the OR-gate 32 to the row decoder 40. Note that in a normal operation when the refresh 11 is high, the AND-gate 28 is enabled to be driven by the external row address 36, while the AND-gate 30 is disabled.

## Claims

1. Method of testing the operation of an internal refresh counter (38) in a random access memory having an external address input (27) for receiving external address signals, a refresh signal input (11) for receiving a refresh signal, further inputs (13, 15, 17) for receiving, respectively, row address strobe, column address strobe and write strobe signals and write circuitry (22), characterized by the following steps:

a) writing a predetermined background into the storage cells of the memory using the external address signals on the external address input (27);

b) selecting a row determined by the row address in the internal refresh counter (38) by means of a first logic circuitry (30, 32, 34) in said random access memory responsive to the refresh signal on the refresh signal input (11);

c) enabling the write circuitry (22) to change the previous background information in at least one selected storage cell of this selected row by means of second logic circuitry (16, 20) in said random access memory responsive to the signals on said further inputs;

d) sequentially repeating steps b. and c. for all other rows selected by the refresh counter (38); and

e) reading the information stored in at least the selected storage cell of each row of the memory by using the external address signals on the external address input and comparing it with the background information previously written in the selected storage cells of the memory.

2. Method according to claim 1, characterized in that the control signal is a refresh signal (REF) received on a refresh signal input (11).

3. Method according to claim 1, characterized in that selection of the storage cells to the respective rows according to Step c. is carried out by column addresses determined by the internal refresh counter (38).

4. Method according to claim 1, characterized in that selection of the storage cells in the respective rows according to Step c. is carried out by column addresses provided on the external address input (27).

5. Circuit for testing the operation of an internal refresh counter (38) in a random access memory having an external address input (27) for receiving external address signals, a refresh signal input (11) for receiving a refresh signal, further inputs (13, 15, 17) for receiving respectively row address strobe, column address strobe and write strobe signals and write circuitry (22), characterized in that there are provided:

means for writing a predetermined background into the storage cells of rows using the external address signals on the external address input (27);

first logic circuit means (30, 32, 34) in said random access memory for selecting row addresses determined by the internal refresh counter (38) in response to the presence of the refresh signal on the refresh signal input (11);

second logic circuit means (16, 20) in said random access memory for enabling the write circuitry (22) to change the previous information included in at least one selected storage cell of each row selected by the internal refresh counter (38) in response to the signals on said further inputs;

means for reading the information in at least the selected storage cell of each row of the memory using the external address signal on the external address input (27); and means for comparing the information read in the selected storage cells with the background information previously written in the selected storage cells.

6. Circuit according to claim 5, characterized in that the control signal input (11) is a refresh signal input (11) for receiving a refresh signal (REF).

7. Circuit of claim 5, characterized in that there are means provided for enabling the write circuitry (22) to change the previous information stored in the selected storage cells at selected column addresses determined by the internal refresh counter (38).

8. Circuit according to claim 5, characterized in that there are means provided for enabling the write circuitry (22) to change the previous information stored in the selected storage cells at selected column addresses determined by the external address signal.

**Patentansprüche**

1. Verfahren zum Prüfen des Betriebes eines inneren Wiederauffrischungs-Zählers (38) in einem Speicher mit wahlfreiem Zugriff mit einem äußeren Adresseingang (27) zum Empfangen von äußeren Adressignalen, einem Wiederauffrischungs-Signaleingang (11) zum Empfangen eines Wiederauffrischungssignals, weiterhin mit Eingängen (13, 15, 17) zum jeweiligen Empfangen von Reihenadressauswahl-Spaltenadressauswahl- und Schreibauswahl-Signalen, und mit einer Schreibschaltung (22), gekennzeichnet durch folgende Verfahrenschritte:

a) Schreiben eines vorbestimmten Hintergrundes in die Speicherzellen des Speichers unter Verwenden der äußeren Adressignale an dem äußeren Adresseingang (27);

b) Auswählen einer Reihe, die durch die Reihenadresse in dem inneren Wiederauffrischungs-Zähler (38) bestimmt ist, mittels einer ersten Logikschaltung (30, 32, 34) in dem Speicher mit wahlfreiem Zugriff in Reaktion auf das Wiederauffrischungs-Signal an dem Wiederauffrischungs-Signaleingang (11);

c) Aktivieren der Schreibschaltung (22), um die vorherige Hintergrundinformation in wenigstens einer ausgewählten Speicherzelle dieser ausgewählten Reihe mittels einer zweiten Logikschaltung (16, 20) in dem Speicher mit wahlfreiem Zugriff in Reaktion auf die Signale an den weiteren Eingängen zu ändern;

d) der Reihe nach Wiederholen der Schritte b) und c) für alle anderen Reihen, die durch den Wiederauffrischungs-Zähler (38) ausgewählt sind; und

e) Lesen der in der wenigstens einen, ausgewählten Speicherzelle jeder Reihe des Speichers gespeicherten Information unter Verwendung der äußeren Adresssignale an dem äußeren Adresseingang und Vergleichen dieser Information mit der vorher in die ausgewählte Speicherzelle des Speichers geschriebenen Hintergrundinformation.

2. Verfahren nach Anspruch 1, dadurch gekennzeichnet, daß das Steuersignal ein Wiederauffrischungs-Signal (REF) ist, das in einem Wiederauffrischungs-Signaleingang (11) empfangen wird.

3. Verfahren nach Anspruch 1, dadurch gekennzeichnet, daß die Auswahl der Speicherzellen in dem jeweiligen Reihen gemäß Verfahrensschritt c) durch Spaltenadressen ausgeführt wird, die durch den inneren Wiederauffrischungs-Zähler (38) bestimmt werden.

4. Verfahren nach Anspruch 1, dadurch gekennzeichnet, daß die Auswahl der Speicherzellen in den jeweiligen Reihen nach Verfahrensschritt c) durch Spaltenadressen ausgeführt wird, die an den äußeren Adresseingängen (27) vorgesehen sind.

5. Schaltung zum Prüfen der Betriebsweise eines inneren Wiederauffrischungs-Zählers (38) in einem Speicher mit wahlfreiem Zugriff, mit einem äußeren Adresseingang (27) zum Empfangen äußerer Adressignale, einem Wiederauffrischungs-Signaleingang (11) zum Empfangen eines Wiederauffrischungs-Signals, mit weiteren Eingängen (13, 15, 17) zum Empfangen jeweiliger Reihenadressauswahl-, Spaltenadressauswahl- und Schreibauswahl-Signale und mit einer Schreibschaltung (22), dadurch gekennzeichnet, daß folgende Merkmale vorgesehen sind;

eine Einrichtung zum Schreiben eines vorbestimmten Hintergrundes in die Speicherzellen der Reihen unter Verwendung von äußeren Adressignalen an dem äußeren Adresseingang (27);

eine erste Logikschaltungeinrichtung (30, 32, 34) in dem Speicher mit wahlfreiem Zugriff zum Auswählen der Reihenadressen, die durch den inneren Wiederauffrischungs-Zähler (38) in Reaktion auf das Vorliegen des Wiederauffrischungs-Signals an den Wiederauffrischungs-Signaleingang (11) bestimmt werden;

eine zweite Logikschaltungseinrichtung (16, 20) in dem Speicher mit wahlfreiem Zugriff zum Aktivieren der Schreibschaltung (22), um die vorherige Information zu ändern, die in wenigstens einer ausgewählten Speicherzelle einer jeden Reihe enthalten ist, die durch den inneren Wiederauffrischungs-Zähler (38) in Reaktion auf die Signale an weiteren Eingängen ausgewählt wird;

eine Einrichtung zum Lesen der Information in der wenigstens einen ausgewählten Speicherzelle jeder Reihe des Speichers unter Verwendung von äußeren Adressignalen an dem äußeren Adresseingang (27); und

eine Einrichtung zum Vergleichen der Information, die in den ausgewählten Speicherzellen gelesen wird, wobei die Hintergrundinformation vorher in die ausgewählten Speicherzellen eingeschrieben wird.

6. Schaltung nach Anspruch 5, dadurch gekennzeichnet, daß der Steuersignaleingang (11) ein Wiederauffrischungs-Signaleingang (11) zum Empfangen eines Wiederauffrischungssignals (REF) ist.

7. Schaltung nach Anspruch 5, dadurch gekennzeichnet, daß eine Schaltung zum Aktivieren der Schreibschaltung (22) vorgesehen ist, um die vorher in den ausgewählten Speicherzellen bei den ausgewählten Spaltenadressen, die durch den inneren Wiederauffrischungs-Zähler (38) bestimmt wird, gespeicherte Information zu ändern.

8. Schaltung nach Anspruch 5, dadurch gekennzeichnet, daß eine Einrichtung zum Aktivieren der Schreibschaltung (22) vorgesehen ist, um die vorher in den ausgewählten Speicherzellen bei den ausgewählten Spaltenadressen, die durch die äußeren Adressignale bestimmt sind, gespeicherte Information zu ändern.

**Revendications**

1. Procédé de test du fonctionnement d'un compteur interne de régénération (38) dans une mémoire à accès sélectif ayant une entrée (27) d'adresse extérieure pour recevoir des signaux d'adresse extérieure , une entrée (11) pour signal de régénération afin de recevoir un signal de régénération, d'autres entrées (13, 15, 17) pour recevoir, respectivement, des signaux d'échantillon d'adresse de rangées, d'échantillon d'adresse de colonne et d'échantillon d'écriture, et un circuit d'écriture (22), caractérisé par les étapes suivantes:

a) l'écriture d'un contexte prédéterminé dans les cellules de stockage de la mémoire utilisant les signaux d'adresse extérieurs sur l'entrée (27) d'adresse extérieure;

b) la sélection d'une rangée déterminée par l'adresse de rangée dans le compteur de régénération interne (38) au moyen d'un premier circuit logique (30, 32, 34) dans la mémoire d'accès sélectif en réponse au signal de régénération sur l'entrée (11) de signal de régénération;

c) la validation du circuit d'écriture (22) pour changer l'information précédente de contexte dans au moins une cellule de stockage sélectionnée de cette rangée sélectionnée au moyen d'un second circuit logique (16, 20) dans la mémoire à accès sélectif en réponse aux signaux appliqués aux autres entrées;

d) la répétition séquentielle des étapes b et c pour toutes les autres rangées sélectionnées par le compteur de régénération (38) et

e) l'écriture de l'information stockée dans au moins la cellule de stockage sélectionnée de chaque rangée de la mémoire par utilisation des signaux d'adresse extérieure appliqués à l'entrée d'adresse extérieure, et sa comparaison avec l'information de contexte précédemment écrite dans les cellules de stockage sélectionnées de la mémoire.

2. Procédé selon la revendication 1, caractérisé en ce que le signal de commande est un signal de régénération (REG) reçu sur une entrée de signal de régénération (11).

3. Procédé selon la revendication 1, caractérisé en ce que la sélection des cellules de stockage dans les rangées respectives selon l'étape c est exécutée par des adresses de colonne déterminées par le compteur de régénération interne (38).

4. Procédé selon la revendication 1, caractérisé en ce que la sélection des cellules de stockage dans les rangées respectives selon l'étape c est exécutée par des adresses de colonne fournies sur l'entrée d'adresse extérieure (27).

5. Circuit de test du fonctionnement d'un compteur de régénération interne (38) dans une mémoire à accès sélectif comportant une entrée d'adresse extérieure (27) pour recevoir des signaux d'adresse extérieure, une entrée (11) de signal de régénération pour recevoir un signal de régénération, d'autres entrées (13, 15, 17) pour recevoir respectivement des signaux d'échantillon d'adresse de rangée, d'échantillon d'adresse de colonne et d'échantillon d'écriture et un circuit d'écriture (22) caractérisé en ce que sont fournis:

— un moyen pour écrire une contexte prédéterminé dans les cellules de stockage des rangées utilisant les signaux d'adresse extérieure appliqués sur l'entrée d'adresse extérieure (27);

— un premier moyen de circuit logique (30, 32, 34) dans la mémoire à accès sélectif pour sélectionner les adresses de rangée déterminées par le compteur de régénération interne (38) en réponse à la présence du signal de régénération sur l'entrée de signal de régénération (11);

— un second moyen de circuit logique (16, 20) dans la mémoire à accès sélectif pour valider le circuit d'écriture (22) afin de changer l'information précédente incluse dans au moins une cellule de stockage présélectionnée de chaque rangée sélectionnée par le compteur de régénération interne (38) en réponse aux signaux appliqués aux autres entrées;

— un moyen pour lire l'information dans au moins la cellule de stockage sélectionnée de chaque rangée de la mémoire en utilisant le signal d'adresse extérieure appliqué à l'entrée d'adresse extérieure (27); et

— un moyen pour comparer l'information lue dans les cellules de stockage sélectionnées avec l'information sur le contexte précédemment écrite dans les cellules de stockage sélectionnées.

6. Circuit selon la revendication 5, caractérisé en ce que l'entrée de signal de commande (11) est une entrée de signal de régénération (11) pour recevoir un signal de régénération (REG).

7. Circuit selon la revendication 2, caractérisé en ce qu'il y a des moyens prévus pour valider le circuit d'écriture (22) pour changer l'information précédente stockée dans les cellules de stockage sélectionnées aux adresses de colonne sélectionnées qui sont déterminées par le compteur de régénération interne (38).

8. Circuit selon la revendication 5, caractérisé en ce qu'il y a des moyens prévus pour valider le circuit d'écriture (22) afin de changer l'information précédente stockée dans les cellules de stockage sélectionnées aux adresses de colonne sélectionnées déterminées par le signal d'adresse extérieure.

FIG. 1

FIG. 2